Europäisches Patentamt

European Patent Office

Office européen des brevets

(11) Publication number: **0 271 070**
**A1**

## (12) EUROPEAN PATENT APPLICATION

(21) Application number: **87118181.4**

(22) Date of filing: **08.12.87**

(51) Int. Cl.⁴: **H01L 21/31** , **H01L 29/62** , **H01L 23/52**

(30) Priority: **08.12.86 JP 293116/86**

(43) Date of publication of application:
**15.06.88 Bulletin 88/24**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Murao, Yukinobu**
**c/o NEC Corporation 33-1, Shiba 5-chome**
**Minato-ku**
**Tokyo(JP)**
Inventor: **Kikuchi, Masanori**
**c/o NEC Corporation 33-1, Shiba 5-chome**
**Minato-ku**
**Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) Semiconductor device with silicide conductive layers and process of fabrication thereof.

(57) For preventing a conductive structure with a refractory metal silicide used for an interconnection and/or a gate electrode from cracks and peelings, there is disclosed a semiconductor device fabricated on a semiconductor substrate (1) and having a conductive structure formed on an insulating film (7), and the conductive structure has a doped polysilicon film (8) formed on the insulating film and a silicon-rich tungsten silicide film (9) formed on the doped polysilicon film.

# FIG. 1

## TITLE OF THE INVENTION

" SEMICONDUCTOR DEVICE WITH SILICIDE CONDUCTIVE LAYERS AND

PROCESS OF FABRICATION THEREOF "

### FIELD OF THE INVENTION

This invention relates to a semiconductor device and, more particularly, to interconnections and/or gate electrodes formed by silicide technology.

### BACKGROUND OF THE INVENTION

Refractory metal silicides such as tungsten silicide ($WSi_2$) have been used for applications as high-conductivity interconnections and/or gate electrodes of various semiconductor devices. These high-conductivity interconnections and gate electrodes alleviate the problems due to large time constants of fine-line polysilicon interconnections and gate electrodes interconnecting component transistors fabricated on the same semiconductor substrate.

A typical process of forming the interconnects using $WSi_2$ or the gate electrodes using $WSi_2$ uses a sputtering technique with a target or cathode of $WSi_2$. For example, an active area is defined in a surface portion of a silicon substrate by a thick field oxide layer and, thereafter, a thin gate oxide film is thermally grown on the active area of the silicon substrate, then a gate structure consisting of a doped polysilicon film and the tungsten silicide film is formed on the thin gate oxide film. Namely, after formation of the doped polysilicon film, the tungsten silicide target is sputtered using a radio frequency

1

discharge which produces ions. The ions are accelerated toward the target of $WSi_2$ for the bombardment, so that a refractory metal silicide film of $WSi_2$ is formed on the doped polysilicon film and is patterned and etched by using conventional lithographic techniques. As a result of these steps, the gate structure consisting of the doped polysilicon film and the tungsten silicide film is provided on the gate oxide film. Each of the interconnections also consists of a polysilicon film and a tungsten silicide film on the polysilicon film, and all of the gate structure and the interconnections are formed by using the target having the stoichiometric composition ratio between tungsten atoms and silicon atoms of 1 : 2. The refractory metal silicide films each having stoichiometric composition are disclosed by A. K. Shinha in "Refractory metal silicides for VLSI applications", J. Vac. Sci. Technol. 19(3), Sept./Oct. 1981, pages 778 to 784.

However, a problem is encountered in the prior-art interconnections and the gate structure in that cracks tend to take place in the tungsten silicide film of $WSi_2$ formed on the doped polysilicon film and that the tungsten silicide films are liable to peel from the doped polysilicon film after heat treatment, typically over 800 degrees in centigrade.

### SUMMARY OF THE INVENTION

It is therefore an important object of the present invention to provide a semiconductor device with a conductive structure having multiple-layer structure formed with a doped polysilicon film and a tungsten silicide film on the doped polysilicon film which withstands high-temperature heat-treatment without cracking and peelings.

It is another important object of the present invention to provide a process of fabricating a semiconductor device with interconnections and/or gate electrodes having a tungsten silicide film formed on a doped polysilicon film which is free from cracks and peelings due to thermal stresses during a high-temperature heat treatment.

To accomplish these objects, the present invention proposes to deviate the composition ratio of the tungsten silicide or the tungsten silicide target from the stoichiometric value.

In accordance with one aspect of the present invention, there is provided a semiconductor device fabricated on a semiconductor substrate and having a conductive structure formed on an insulating film, wherein the conductive structure has a doped polysilicon film formed on the insulating film and a silicon-rich tungsten silicide.

The tungsten silicide layer may be formed of a silicon-rich tungsten silicide having a composition of $WSi_x$ where x ranges between 2.3 to 2.8. The conductive structure is available to form a gate electrode of a field effect transistor and/or an interconnection. The doped polysilicon film may have a thickness ranging between about 1000 angstroms and 3000 angstroms, and the tungsten silicide film may have a thickness ranging between about 1000 angstroms and about 3500 angstroms.

3

In accordance with another aspect of the present invention, there is provided a process of fabricating a semiconductor device comprising the steps of a) providing a semiconductor substrate having an insulating film, and b) forming a conductive structure on the insulating film, the conductive structure having a doped polysilicon film formed on the insulating film and a tungsten silicide film formed on the doped polysilicon film, the tungsten silicide film being formed by sputtering a target of a silicon-rich tungsten silicide.

The target may have a composition of $WSi_x$ where x ranges between 2.6 and 2.9.

## BRIEF DESCRIPTION OF THE DRAWINGS

The features and advantages of a semiconductor device with silicide conductive layers and a process of fabrication thereof according to the present invention will be more clearly understood from the following description taken in conjunction with the accompanying drawings in which:

Fig. 1 is a cross-sectional view showing the structure of a semiconductor device embodying the present invention;

Figs 2A to 2F are cross-sectional views showing the steps of a process for fabricating the semiconductor device illustrated in Fig. 1;

Fig. 3 is a graph showing the relationship between a target with a composition and a percentage of abnormal surface occurrence; and

Fig. 4 is a cross-sectional view showing another structure

4

of a semiconductor device embodying the present invention.

## DESCRIPTION OF THE PREFERRED EMBODIMENTS

### First Embodiment

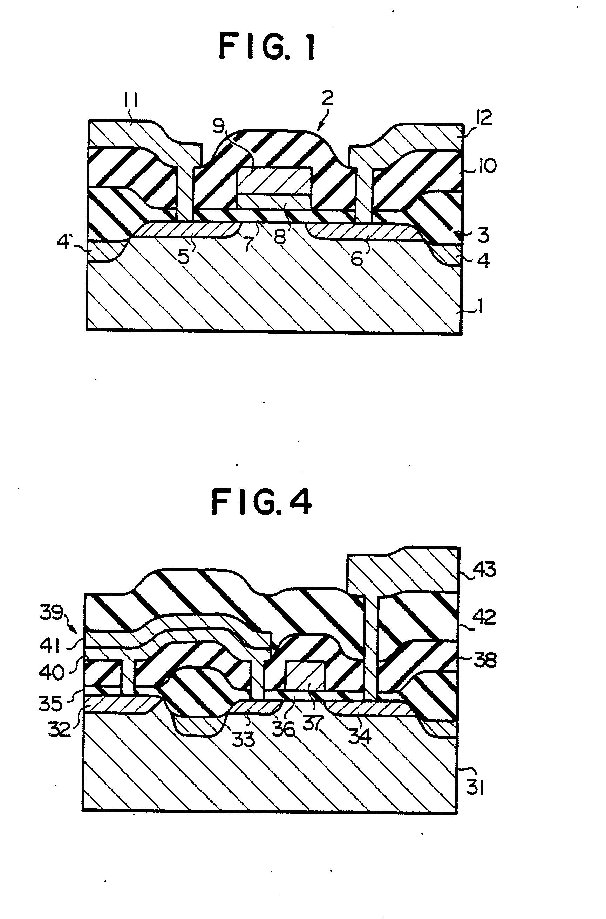

Referring to Fig. 1 of the drawings, there is shown the structure of a semiconductor device embodying the present invention. The semiconductor device illustrated in Fig. 1 is fabricated on a p-type silicon substrate 1 having a resistivity of about 1 ohm-cm and comprises a MOS type field effect transistor 2 which is formed in an active device area defined by a relatively thick field oxide film 3. A p+ type channel stopper regions 4 is provided beneath the field oxide film 3 and the two n-type impurity regions 5 and 6 serving as source and drain regions are formed in the surface portion of the active device area. On the surface portion of the active device area is thermally grown a thin gate oxide film 7 of silicon dioxide which has a thickness of about 400 angstroms, and a gate electrode structure in turn is formed on the thin gate oxide film 7. the gate electrode structure comprises a heavily doped polysilicon film 8 of about 2000 angstroms thick and a tungsten silicide ($WSi_x$) film 9 of about 3000 angstroms thick deposited on the upper surface of the heavily doped polysilicon film 8. The heavily doped polysilicon film 8 may have a thickness ranging between about 1000 angstroms and about 3000 angstroms, and the tungsten silicide film 9 may have a thickness between about 1000 angstroms and about 3500 angstroms. In this instance, the tungsten silicide film 9 has a composition of $WSi_{2.3}$ or the number of tungsten atoms and the number of silicon atoms are in the ratio 1 : 2.3, so that the tungsten silicide film 9 has the composition ratio deviated from the stoichiometric value. The gate electrode structure is covered with a thick intermediate insulating layer 10 of above 1 micron which is formed with contact windows reaching the surfaces of the n-type impurity regions 5 and 6, respectively. Aluminum wiring layers or interconnections 11 and 12 are provided on the intermediate insulating layer 10 and have respective lug portions which pass through the contact windows to come into contact with the surfaces of the n-type impurity regions 5 and 6, respectively.

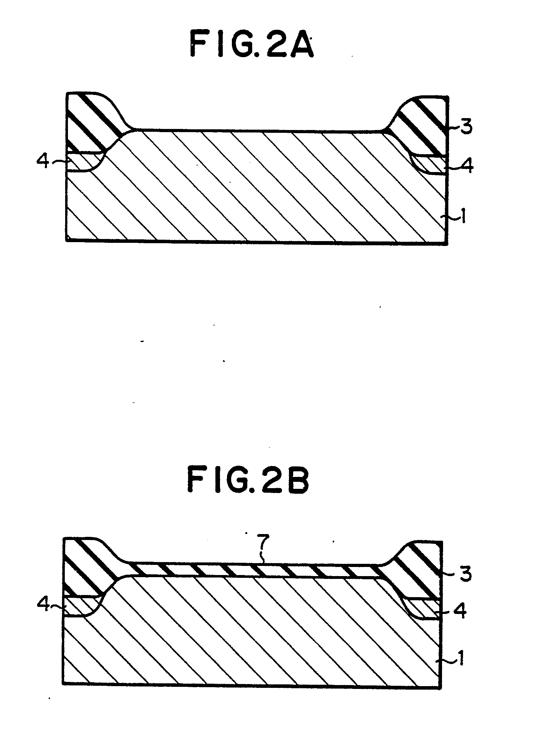

Figs. 2A to 2F show a fabrication process of the semiconductor device illustrated in Fig. 1. The starting material is the lightly doped p-type silicon substrate 1 having a resistivity of about 1 ohm-cm, and a thin silicon oxide film is thermally grown, followed by a silicon nitride deposition to form a composite nitride-oxide layer. The active device area is defined by a photoresist mask, and p-type impurities such as, for example, boron atoms are then implanted through the composite nitride-oxide layer. An appropriate etchant selectively removes the exposed silicon nitride film where the photoresist mask is not applied and, thereafter, the photoresist mask is stripped off by an etching technique. After stripping the photoresist mask, the silicon substrate 1 is placed in an oxidation furnace (not shown) to grow the thick field oxide film 3 in the area where the silicon nitride film is removed. During the thermal oxidation in

6

the furnace, the boron atoms are driven in to form the channel stopper region 4 and the thick field oxide film is thermally grown to a thickness of about 5000 angstroms to 10000 angstroms. When the thick field oxide film 3 is formed, the active device area is exposed by removing the composite nitride-oxide layer consisting of the silicon nitride film and the silicon dioxide film. The resultant structure is shown in Fig. 2A.

The subsequent step is formation of the gate oxide film 7. The silicon substrate is placed in the oxidation furnace again so that a fresh silicon oxide is thermally grown to a thickness of about 400 angstroms on the active device area and the fresh silicon oxide film provides the gate oxide film 7 of the MOS type field effect transistor 2 as will be seen from Fig. 2B.

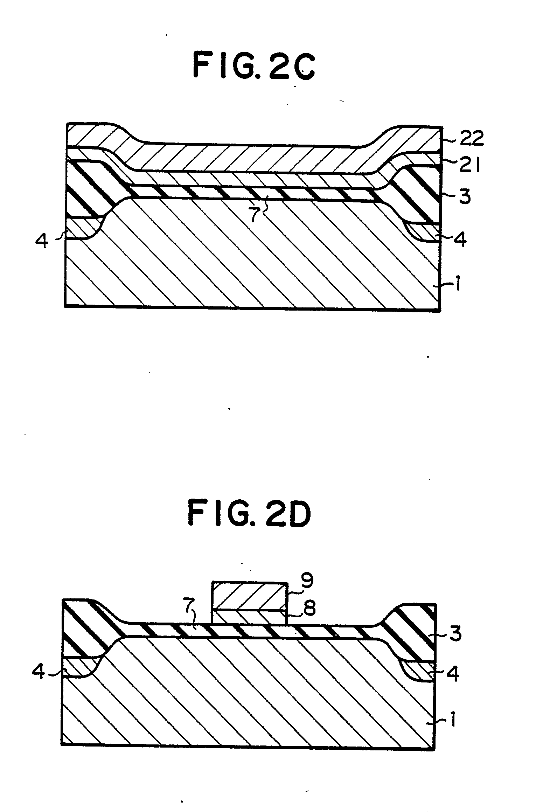

Formation of the gate electrode structure follows. On the structure illustrated in Fig. 2B is deposited a polysilicon film 21 to a thickness of about 2000 angstroms by a chemical vapor deposition technique, and the polysilicon film 21 is heavily doped with phosphorus atoms by using a diffusion technique. When the heavily doped polysilicon film 21 is formed on the entire surface of the resultant structure illustrated in Fig. 2B, a tungsten silicide ($WSi_x$) film 22 is deposited to a thickness of about 3000 angstroms by a sputtering technique using a target or cathode having a composition of $WSi_{2.8}$. In other words, the number of tungsten atoms and the number of silicon atoms are in the ratio 1 : 2.8. The resultant structure of this step is illustrated in Fig. 2C. Appropriate lithographic processes are

7

applied to form the gate structure having the heavily doped polysilicon film 8 and the tungsten silicide film 9 with the composition of $WSi_{2.3}$ (as will be seen Fig. 2D). In this instance, the heavily doped polysilicon film 8 and the tungsten silicide film 9 are registry with each other. After the formation of the gate electrode structure, a heat treatment of about 1000 degrees in centigrade is applied to the resultant structure to reduce the resistance of the tungsten silicide film 9.

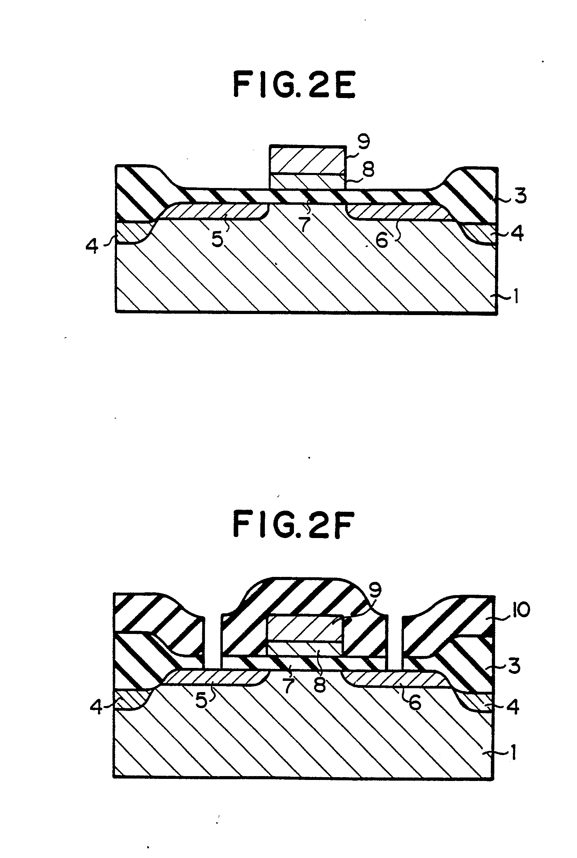

Subsequently, phosphorus atoms are implanted into the active device area using the gate electrode structure as a mask to form the n-type impurity regions 5 and 6 serving as the source and drain regions of the MOS type field effect transistors. The phosphorus ion implantation is carried out at a dose of about 1 x $10^{16}$ $cm^{-2}$ and the accelerator is selected to be at about 100 KeV. After the phosphorus ion implantation, the silicon substrate 1 is placed in a furnace for activation of the n-type impurity regions 5 and 6 at a high-temperature of about 900 degrees in centigrade. The gate electrode formed on the gate oxide film 7 and two n-type impurity regions 5 and 6 form in combination the MOS type field effect transistor as illustrated in Fig. 2E.

After formation of the gate electrode, an insulating film of, for example, silicon dioxide is deposited to a thickness of about 1 micron by using a chemical vapor deposition technique, so that the gate structure is covered with the intermediate insulating film 10. In the intermediate insulating film 10 are

8

formed contact windows which is opened at the upper surface of the n-type impurity regions 5 and 6, respectively, as will be seen from Fig. 2F. Subsequently, an aluminum-silicon alloy is deposited over the entire surface of the resultant structure and the aluminum-silicon alloy is patterned and etched to form the aluminum wiring layers 11 and 12 by using lithographic techniques. As the contact windows are formed in the intermediate·insulating layer 10, the aluminum wiring layers 11 and 12 have the respective lug portions which respectively pass through the contact windows to come into contact with the n-type impurity regions 5 and 6. Thus, the semiconductor device structure illustrated in Fig. 1 is achieved. Though not shown in the drawings, the semiconductor device structure illustrated in Fig. 1 is covered with a passivation film (not shown) and housed in an appropriate package.

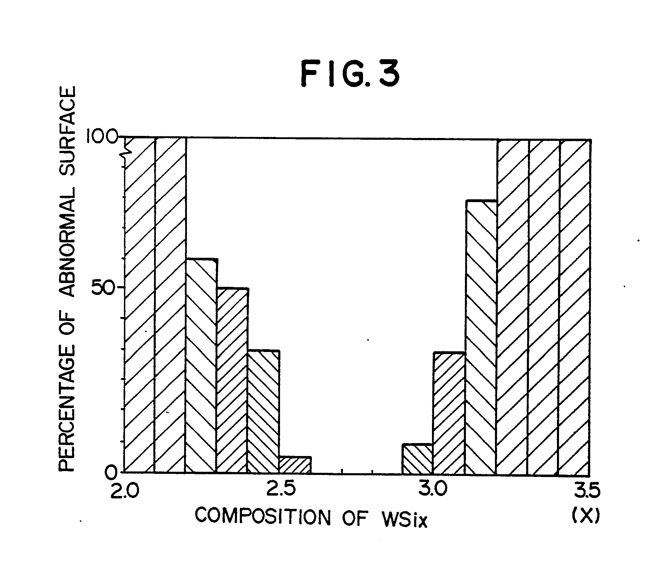

In this instance, the tungsten silicide film 9 is formed on the heavily doped polysilicon film 8 by the sputtering technique using the target having the composition of $WSi_{2.8}$. However, the composition of $WSi_x$ can be selected from the range where x is between 2.6 and 2.9. According to an experiment in which a plurality of tungsten silicide films are formed on respective heavily doped polysilicon films by the sputtering using various targets each having $WSi_x$ composition where x is between 2.0 and 3.5, the tungsten silicide films clearly have an abnormal surfaces with, for example, liftings, cracks or peelings except for using the targets each having $WSi_x$ where x is 2.6 to 2.9. In detail, 120 chips are formed in a four inches semiconductor wafer and each of the chips has a large number of multiple-layer structure each consisting of a polysilicon film of 2000 angstroms thick doped with phosphorus atoms of about $3 \times 10^{21}$ cm$^{-3}$ and a tungsten silicide film of about 2500 angstroms thick using a target of a tungsten silicide WSi$_x$. Then, the wafer formed with the 120 chips is placed in an oxidation ambient at about 900 degrees in centigrade for 30 minutes. After the heat treatment, if only one crack, peeling or lifting is observed in the tungsten silicide film of the multiple-layer structures, this chip is decided to be a chip with the abnormal surface. Fig. 3 shows the result of the experiment, the abscissa indicates "x" of the composition WSi$_x$ of the target used for formation of the multiple-layer structures, and the ordinate indicates percentage of the chip with the abnormal surfaces. In other words, the ordinate indicates the quotient of (the number of chips with the abnormal surface)/120. The tungsten silicides without the abnormal surface are analyzed to decide the composition of WSi$_x$. According to the analysis, the tungsten silicides without abnormal surface have a WSi$_x$ composition where x is between 2.3 and 2.8.

## Second Embodiment

Turning to Fig. 4 of the drawings, there is shown another structure of a semiconductor device embodying the present invention. The semiconductor device illustrated in Fig. 4 is fabricated on a lightly-doped p-type monocrystalline silicon

10

substrate 31. In the surface portion of the silicon substrate 31 are formed n-type impurity regions 32, 33 and 34 which are separated from one another and covered with gate oxide films 35 and 36. On the gate oxide film 36 is provided a gate electrode 37 of a doped polysilicon which forms a MOS type field effect transistor together with the n-type impurity regions 33 and 34. A first level intermediate insulating film covers the entire surface of the structure and provides contact holes reaching the upper surfaces of the n-type impurity regions 32, 33 and 34, respectively. The n-type impurity region 32 is electrically connected to the n-type impurity regions 33 through an interconnection 39 and the interconnection 39 comprises a composite layer structure consisting of a heavily doped polysilicon film 40 and a tungsten silicide film 41. The heavily doped polysilicon film 40 and the tungsten silicide film 41 are registry with each other. The heavily doped polysilicon film 40 has lug portions passing through the contact holes to come into contact with the upper surfaces of the n-type impurity regions 32 and 33, respectively. Thus, the interconnection 39 provides an conduction path between the n-type impurity regions 32 and 33. The semiconductor device illustrated in Fig. 4 uses the interconnection 39 of the composite layer structure so that the semiconductor device can have an upper wiring layer. Namely, the interconnection 39 is covered with a second level intermediate insulating film 42 of, for example, silicon dioxide, and a second level interconnection 43 of an aluminum is formed on the second

11

level intermediate insulating film 42.    The second level intermediate insulating film 42 is formed with a contact hole which is aligned with the contact hole exposing the upper surface of the n-type impurity region 34, so that a lug portion of the second level interconnection 43 passes through the contact holes to come into contact with the upper surface of the n-type impurity region 34.

All of the embodiment hereinbefore described have one of the gate electrode and the interconnection to which the present invention appertains, however it is possible to have both of the gate electrode of a tungsten silicide and the interconnection of a tungsten silicide.

Although particular embodiment of the present invention have been shown and described, it will be obvious to those skilled in the art that various changes and modifications may be made without departing from the spirit and scope of the present invention.

## CLAIMS

1.    A semiconductor device fabricated on a semiconductor substrate and having a conductive structure formed on an insulating film, <u>characterized in that</u> said conductive structure has a doped polysilicon layer formed on said insulating film and a silicon-rich tungsten silicide film formed on the doped polysilicon film.

2.    A semiconductor device as set forth in claim 1, in which said silicon-rich tungsten silicide has a composition of $WSi_x$ where x ranges between 2.3 to 2.8.

3.    A semiconductor device as set forth in claim 1, in which said conductive structure serves as a gate electrode of a field effect transistor.

4.    A semiconductor device as set forth in claim 1, in which said conductive structure serves as an interconnection.

5.    A semiconductor device as set forth in claim 1, in which said doped polysilicon film has a thickness ranging between about 1000 angstroms and about 3000 angstroms.

6.    A semiconductor device as set forth in claim 1, in which said silicon-rich tungsten silicide film has a thickness ranging between about 1000 angstroms and about 3500 angstroms.

7.    A process of fabricating a semiconductor device comprising the steps of:

    a) providing a semiconductor substrate having an insulating film; and

    b) forming a conductive structure on said insulating film,

said conductive structure having a doped polysilicon film formed on said insulating film and a tungsten silicide film formed on the doped polysilicon film, said tungsten silicide film being formed by sputtering a target of a silicon-rich tungsten silicide.

8. A process of fabricating a semiconductor device as set forth in claim 6, in which said target having a composition of $WSi_x$ where x ranges between 2.6 and 2.9.

# FIG. 1

# FIG. 4

**FIG.2A**

**FIG.2B**

# FIG. 2C

22
21
3
7
4
4
1

# FIG. 2D

9
7
8
3
4
4
1

# FIG. 2E

# FIG. 2F

# FIG. 3

PERCENTAGE OF ABNORMAL SURFACE

COMPOSITION OF WSix (X)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JOURNAL OF THE ELECTROCHEMICAL SOCIETY, vol. 133, no. 4, April 1986, pages 794-798, Manchester, NH, US; J. KATO et al.: "Rapid annealing of tungsten polycide films using halogen lamps" * Page 794, column 1, paragraph 3 - page 795, column 1, paragraph 1; figure 1 * | 1-8 | H 01 L 21/31 H 01 L 29/62 H 01 L 23/52 |
| X | US-A-4 443 930 (NCR CORP.) * Claims 1-14 * | 1-8 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 11-01-1988 | VANCRAEYNEST F.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................
& : member of the same patent family, corresponding document

EPO FORM 1503 03.82 (P0401)